(19) Europäisches Patentamt / European Patent Office / Office européen des brevets

(11) **EP 2 728 823 B1**

(12) **FASCICULE DE BREVET EUROPEEN**

(45) Date de publication et mention de la délivrance du brevet:
**18.07.2018 Bulletin 2018/29**

(51) Int Cl.:
*H04L 27/20* *(2006.01)*      *H04L 1/00* *(2006.01)*
*G06K 19/07* *(2006.01)*

(21) Numéro de dépôt: **13190793.3**

(22) Date de dépôt: **30.10.2013**

(54) **Méthode et dispositif de modulation numérique à faible densité de transitions**

Verfahren und Vorrichtung zur digitalen Modulierung mit niedriger Densität an Übergängen

Method and apparatus for digital modulation with low density of transitions

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.11.2012 FR 1260460**

(43) Date de publication de la demande:
**07.05.2014 Bulletin 2014/19**

(73) Titulaire: **Commissariat à l'Énergie Atomique et aux Énergies Alternatives
75015 Paris (FR)**

(72) Inventeurs:
• **Pebay-Peyroula, Florian
  38250 SAINT-NIZIER-DU-MOUCHEROTTE (FR)**
• **Dore, Jean-Baptiste
  38950 SAINT MARTIN LE VINOUX (FR)**

(74) Mandataire: **Augarde, Eric et al
Brevalex
56 Boulevard de l'Embouchure,
Bât. B
B.P. 27519
31075 Toulouse Cedex 2 (FR)**

(56) Documents cités:
• **LITZENBURGER M ET AL: "A comparison of trellis shaping schemes for controlling the envelope of a bandlimited PSK-signal", VEHICULAR TECHNOLOGY CONFERENCE, 1994 IEEE 44TH STOCKHOLM, SWEDEN 8-10 JUNE 1994, NEW YORK, NY, USA,IEEE, 8 juin 1994 (1994-06-08), pages 982-986, XP010123222, DOI: 10.1109/VETEC.1994.345238 ISBN: 978-0-7803-1927-1**

**Description**

**DOMAINE TECHNIQUE**

La présente invention concerne de manière générale le domaine de la modulation numérique. Elle s'applique plus particulièrement aux systèmes de communication en champ proche, tels que les systèmes RFID (*Radio Frequency Identification*) ou les systèmes NFC (*Near Field Communication*).

**ÉTAT DE LA TECHNIQUE ANTÉRIEURE**

Les systèmes de communication en champ proche (RFID, NFC) sont très largement répandus dans le grand public.

Initialement destinés à transférer de faibles quantités de donnés, ces systèmes requièrent désormais pour certaines nouvelles applications (transfert de fichiers biométriques stockés dans les passeports électroniques, transfert de fichiers d'image stockés dans les dossiers médicaux, etc.) de pouvoir transmettre une quantité importante d'information dans des temps très brefs.

Aussi, a-t-il été proposé dans le cadre de la norme ISO 14443 relative aux cartes d'identification sans contact, une évolution des caractéristiques de la couche physique permettant de supporter de très hauts débits (jusqu'à 27.12 Mbits/s). Plus généralement, la norme ISO 14443 définit les caractéristiques auxquelles doit se conformer une communication bidirectionnelle entre un lecteur sans contact, encore dénommé PCD (*Proximity Coupling Device*) et un transpondeur passif ou PICC (*Passive Inductive Coupled Card*).

Sur la voie montante, le transpondeur passif transmet les informations en modulant la phase d'une porteuse de fréquence $F_{sc}$, la modulation de phase étant réalisée en connectant et déconnectant simplement l'antenne à une charge. Les bits à transmettre font l'objet d'une modulation BPSK (*Binary Phase Shift Keying*), les symboles BPSK modulant la porteuse à une fréquence de modulation $F_s = F_{sc}/n$ où $n$ est un entier.

Réciproquement, sur la voie descendante, il est prévu dans la norme en question, que le lecteur sans contact, puisse transmettre à haut débit (6.8 Mbits/s à 27.12 Mbits/s) à l'aide d'une modulation $M$-PSK. Plus précisément, les bits sont convertis en des symboles d'un alphabet de modulation $M$-PSK, chaque symbole étant transmis pendant un temps symbole $T_s=1/F_s$. Le degré de modulation, c'est-à-dire le cardinal de l'alphabet de modulation, ainsi que le temps symbole donnent le bit rate.

Actuellement, le degré de modulation $M$ est fixé à 2, un bit égal à 0 étant transmis avec une phase $-\Phi/2$ et un bit égal à 1 avec une phase $\Phi/2$ où $\Phi$ est un angle inférieur à $\pi/2$. La valeur de $\Phi$ est choisie de préférence relativement faible pour minimiser les discontinuités du signal, par exemple $\Phi=\pi/8$.

Le signal transmis par le lecteur peut s'exprimer sous la forme :

$$s(t) = A\cos\left(2\pi F_c + m(t) + \varphi_0\right) \qquad (1)$$

où $A$, $F_c$ et $\varphi_0$ sont respectivement l'amplitude, la fréquence et la phase à l'origine de la porteuse et où $m(t)$ est le terme de modulation de phase donné par :

$$m(t) = \sum_k \Phi_k g(t - kT_s) \qquad (2)$$

où $\Phi_k$ est la phase du kième symbole PSK et $g(t)$ est une fonction de mise en forme par exemple la fonction créneau définie par :

$$g(t) = 1 \text{ si } 0 \leq t < T_s$$

$$g(t) = 0 \text{ sinon} \qquad (3)$$

Au niveau du PICC, le signal reçu est translaté en bande de base, échantillonné avec une fréquence $F_s$ et les échantillons obtenus, $r_k$, peuvent s'exprimer sous la forme :

$$r_k = a_k e^{j\Phi_k} \qquad (4)$$

où $a_k$ est l'amplitude (réel positif) de l'échantillon et $\Phi_k$ sa phase. On suppose une synchronisation parfaite de l'échantillonnage par rapport aux symboles reçus.

Les échantillons ainsi obtenus font ensuite l'objet d'une démodulation différentielle de phase. De manière équivalente, la démodulation différentielle de phase peut être réalisée en analogique et le résultat échantillonné est converti en numérique. Dans tous les cas, le démodulateur différentiel fournit la différence de phase entre deux échantillons consécutifs du signal en bande de base :

$$y_k = \arg(r_k r_{k-1}^*) \tag{5}$$

où $\arg(z)$ représente la phase du nombre complexe $z$ et.* est la conjugaison de phase.

En absence d'interférence intersymbole et de bruit sur le canal de transmission, la phase $y_k$ en sortie du démodulateur différentiel n'est autre que :

$$y_k = \Phi_k - \Phi_{k-1} \tag{6}$$

Ainsi, si l'on connaît la phase de départ on peut en déduire les phases $\Phi_k$ et donc les bits transmis.

Lorsque les bits d'information sont constitués par une séquence alternée de 0 et de 1, les symboles de modulation forment une série de valeurs complexes alternant entre $e^{j\Phi/2}$ et $e^{-j\Phi/2}$, autrement dit la sinusoïde modulée par les symboles de modulation présente un saut de phase de $\Phi$ à chaque période symbole $T_s$.

Il en résulte que le signal modulé peut être de spectre relativement large et, par conséquent, sujet à atténuation de ses hautes fréquences, étant donné la bande passante limitée du canal de transmission (incluant le démodulateur différentiel). L'atténuation des hautes fréquences du signal conduit à une augmentation du taux d'erreur binaire (BER) au niveau du récepteur.

Le but de la présente invention est de proposer une méthode de codage et de modulation, par exemple pour l'émetteur d'un lecteur PCD, qui permette d'obtenir un spectre de signal modulé plus étroit que dans l'art antérieur, ce pour un même débit binaire de transmission.

Le document "A comparison of trellis shaping schemes for controlling the envelope of a bandlimited PSK-signal", 8 juin 1994, pages 982-986 (Litzenburger et al.) décrit une méthode de modelage de trellis (trellis shaping) pour contrôler l'enveloppe d'un signal module en modulation PSK et plus précisément pour réduire les sauts importants de phase: ceci est obtenu grâce a un calcul de l'inverse d'un syndrome, à la sélection d'un chemin dans le treillis par l'algorithme de Viterbi et au re-encodage.

## EXPOSÉ DE L'INVENTION

La présente invention est définie comme une méthode de modulation numérique transformant une séquence de mots d'entrée ($w_k$), constitués chacun de $m$ symboles d'information, en une séquence de symboles de modulation M-PSK où $M = 2^m$, ladite méthode comprenant :

- une étape de transcodage dans laquelle chaque mot d'entrée ($w_k$) est codé en un mot de code ($w'_k$) de longueur variable au moyen d'une table de transcodage, la table de transcodage codant au moins un premier mot d'entrée, induisant un premier nombre de transitions de phase dans ladite séquence de symboles de modulation, en un second mot de taille supérieure à $m$, induisant un second nombre de transitions de phase inférieur au dit premier nombre dans ladite séquence ;
- une étape de concaténation des mots de code ($w'_k$) obtenus à l'étape précédente pour fournir une séquence de mots de sortie $(w''_k)$, chaque mot de sortie étant constitué de $m$ symboles d'information ;
- une modulation M-PSK fournissant pour chaque mot de sortie de la séquence un symbole M-PSK correspondant.

Selon une première variante, la table de transcodage fournit un mot de code $w'_k$ pour chaque mot d'entrée $w_k$, le mot de code $w'_k$ dépendant du mot d'entrée en question ainsi que de l'état du transcodeur, l'état du transcodeur étant déterminé par les $K$ derniers mots d'entrée du transcodeur et les $K'$ derniers mots de code fournis par le transcodeur, où $K$ et $K'$ sont des entiers supérieurs ou égaux à 1.

Selon une seconde variante, la table de transcodage fournit un mot de code $w'_k$ pour chaque mot d'entrée $w_k$, le mot de code $w'_k$ dépendant du mot d'entrée en question ainsi que de l'état du transcodeur, l'état du transcodeur étant déterminé par les $K$ derniers mots d'entrée du transcodeur, où $K$ est un entier supérieur ou égal à 1.

Typiquement, les symboles d'information sont constitués chacun par un bit et les mots d'entrée ainsi que les mots de sortie sont alors binaires, et $M = 2$.

Avantageusement, un mot binaire d'entrée $w_k$ induisant dans la séquence de symboles de modulation $\mu_k = (K+1)m-1$ transitions de phase est codé en un mot $w'_k$ de taille $m+1$, dont tous les bits ont la même valeur.

Selon un premier exemple de réalisation, $K=1$, $m=1$, et la table de transcodage est donnée par :

| $w_{k-1}$ | $w_k$ | $w'_k$ |
|---|---|---|
| 0 | 0 | 0 |
| 1 | 0 | 11 |
| 0 | 1 | 00 |
| 1 | 1 | 1 |

Selon un second exemple de réalisation, $K = 1$, $m= 1$, et la table de transcodage est donnée par :

| $w_{k-1}$ | $w_k$ | $w'_k$ |
|---|---|---|
| 0 | 0 | 0 |
| 1 | 0 | 0 |
| 0 | 1 | 11 |
| 1 | 1 | 1 |

Selon un troisième exemple de réalisation, $K = 1$, $m= 1$, et la table de transcodage est donnée par :

| $w_{k-1}$ | $w_k$ | $w'_k$ |
|---|---|---|
| 0 | 0 | 0 |
| 1 | 0 | 00 |
| 0 | 1 | 1 |
| 1 | 1 | 1 |

L'étape de modulation 2-PSK transforme par exemple un bit d'une première valeur en e $e^{-j\frac{\Phi}{2}}$ et un bit d'une seconde valeur, inverse de la première valeur en $e^{+j\frac{\Phi}{2}}$ où $\Phi$ est un angle inférieur à $\pi/2$.

L'invention concerne également un modulateur numérique transformant une séquence de mots d'entrée ($w_k$), constitués chacun de symboles d'information, en une séquence de symboles de modulation M-PSK où $M = 2^m$, ledit modulateur comprenant :

- un transcodeur dans lequel chaque mot d'entrée est codé en un mot de code de longueur variable au moyen d'une table de transcodage stockée au sein du transcodeur, la table de transcodage codant au moins un premier mot, induisant un premier nombre de transitions de phase dans ladite séquence de symboles de modulation, en un second mot de taille supérieure à $m$ induisant un second nombre de transitions de phase inférieur au dit premier nombre dans ladite séquence ;
- un registre FIFO adapté à concaténer des mots de code obtenus à l'étape précédente pour fournir une séquence de mots de sortie ( $w''_k$ ), chaque mot de sortie étant constitué de $m$ symboles d'information;
- un modulateur M-PSK fournissant pour chaque mot de sortie un symbole M-PSK correspondant.

Selon un première variante, la table de transcodage fournit un mot de code $w'_k$ pour chaque mot d'entrée $w_k$, le mot de code $w'_k$ dépendant du mot binaire en question ainsi que de l'état du transcodeur, l'état du transcodeur étant déterminé par les $K$ derniers mots d'entrée du transcodeur et les $K'$ derniers mots de code fournis par le transcodeur, où $K$ et $K'$ sont des entiers supérieurs ou égaux à 1.

Selon une seconde variante, la table de transcodage fournit un mot de code $w'_k$ pour chaque mot d'entrée $w_k$, le mot de code $w'_k$ dépendant du mot binaire en question ainsi que de l'état du transcodeur, l'état du transcodeur étant déterminé par les $K$ derniers mots binaires en entrée du transcodeur, où $K$ est un entier supérieur ou égal à 1.

## BRÈVE DESCRIPTION DES DESSINS

La Fig. 1 représente de manière schématique un dispositif de modulation numérique selon un premier mode de réalisation de l'invention ;

La Fig. 2A représente un premier exemple de table de transcodage pour le dispositif de modulation numérique de la Fig.1, lorsque les mots d'entrée sont de 1 bit ;

La Fig. 2B représente un second exemple de table de transcodage pour le dispositif de modulation numérique de la Fig. 1 lorsque les mots d'entrée sont de 1 bit ;

La Fig. 2C représente un troisième exemple de table de transcodage pour le dispositif de modulation numérique de la Fig. 1 lorsque les mots d'entrée sont de 1 bit ;

La Fig. 3A représente un quatrième exemple de table de transcodage pour le dispositif de modulation numérique de la Fig. 1 lorsque les mots d'entrée sont de 2 bits ;

La Fig. 3B représente un cinquième exemple de table de transcodage pour le dispositif de modulation numérique de la Fig. 1, lorsque les mots d'entrée sont de 2 bits.

La Fig. 4 représente de manière schématique un dispositif de modulation numérique selon un second mode de réalisation de l'invention ;

La Fig. 5 représente un sixième exemple de table de transcodage pour le dispositif de modulation numérique de la Fig. 4.

## EXPOSÉ DÉTAILLÉ DE MODES DE RÉALISATION PARTICULIERS

Nous considérerons dans la suite un émetteur, par exemple l'émetteur d'un lecteur PCD, adapté à transmettre une information se présentant sous la forme de mots de $m$ symboles d'information.

La transmission peut se faire par paquets, chaque paquet comprenant un entête suivi d'une charge utile, la charge utile étant constituée d'une séquence de $m$ symboles d'informations.

Chaque symbole d'information est mappé sur un symbole de modulation M-PSK où $M = 2^m$.

Dans le cas particulier où les symboles d'information sont des bits, chaque valeur de bit est mappée sur un symbole de modulation 2-PSK, par exemple le bit 0 est mappé sur le symbole $e^{-j\frac{\Phi}{2}}$ et le bit 1 sur le symbole $e^{+j\frac{\Phi}{2}}$.

Les symboles de modulation ainsi obtenus sont utilisés pour moduler une porteuse à la fréquence $F_{sc}$. L'émetteur transmet sur le canal de transmission, le signal obtenu par modulation de la porteuse, éventuellement après translation en fréquence.

La transformation des mots de $m$ symboles d'information en symboles de modulation M-PSK est effectuée par un modulateur numérique selon l'invention.

Pour simplifier la présentation, mais sans préjudice de généralisation, nous envisagerons plus particulièrement dans le site le cas où ces symboles d'information sont des bits. Toutefois, de manière générale, l'homme du métier comprendra que ces symboles d'information peuvent être constitués par un ou plusieurs bits.

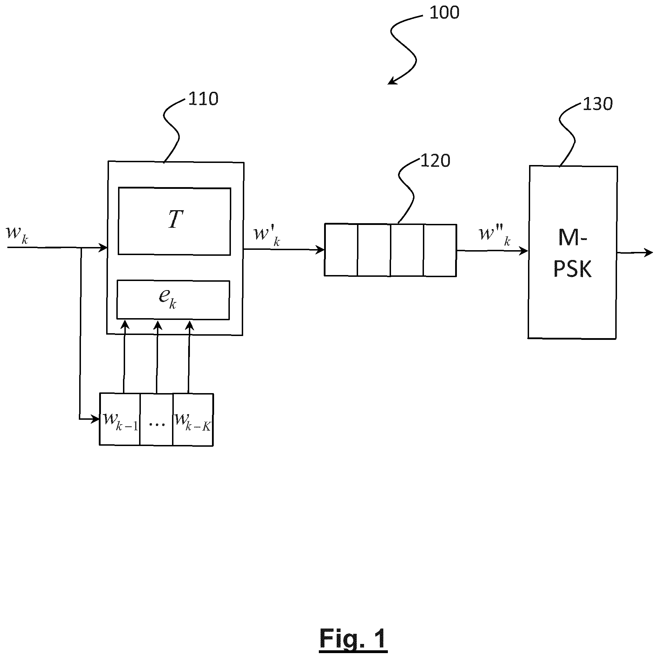

La Fig. 1 représente un dispositif de modulation numérique selon un premier mode de réalisation de l'invention.

Ce système de modulation numérique, 100, comprend un transcodeur, 110, transformant les mots de $m$ symboles d'information en mots de longueur variable selon une table de transcodage $T$ décrite plus loin.

Le transcodeur fonctionne comme une machine à états finis, le mot fourni en sortie à chaque période de codage $k$ dépendant de l'état du transcodeur et du mot présent à son entrée. Plus précisément, le transcodeur transforme un mot en entrée $w_k$ constitué de $m$ symboles d'information en un mot $w'_k$ de longueur variable, tel que :

$$w'_k = F\left(w_k \middle| e_k\right) \tag{7}$$

où $e_k$ désigne l'état du transcodeur à l'instant $k$ et $F(w_k|e_k)$ est la réponse du transcodeur au mot $w_k$ lorsqu'il est dans l'état $e_k$. La fonction $F$ est définie par une table de transcodage $T$ stockée dans le transcodeur.

De manière générale l'état $e_k$ peut dépendre des $K$ mots précédents $w_{k-1},..., w_{k-K}$.

Les mots de longueur variable, $w'_k$, sont stockés les uns à la suite des autres dans un registre FIFO First In First Out), 120. Autrement dit, les mots sont concaténés de manière à former une suite de symboles d'information dans le registre 120.

De manière générale, le registre FIFO fournit un mot de $m$ symboles d'information, chaque symbole d'information étant ensuite transformé en un symbole M-PSK par le modulateur 130. On comprendra que le registre FIFO permet de passer d'une séquence de mots de longueur variable à une séquence de mots de longueur fixe égale à $m$.

Dans le cas où les symboles d'information sont des bits, le registre FIFO fournit un mot de $m$ bits, $w''_k$, à chaque période de modulation, chacun des bits de $w''_k$ étant ensuite transformé en un symbole 2-PSK par le modulateur binaire à symbole 130.

Dans ce cas, Toute transition binaire d'un bit 1 à un bit 0 ou inversement d'un bit 0 à un bit 1 se traduit par un saut de phase en sortie. Lorsque ces sauts de phase sont fréquents, le spectre du signal modulé est relativement large.

L'idée à la base de la présente invention est de réduire la densité de transitions de phase en sortie du modulateur binaire à symbole 130 grâce à un codage de longueur variable. Plus précisément, le transcodeur transforme le mot $w_k$ en un mot $w'_k$, tel que la séquence de $K+1$ mots :

$$v'_k = w'_k\, w_{k-1} ... w_{k-K} \qquad (8)$$

donne en sortie du modulateur un nombre de transitions de phase plus faible que celui la séquence originale :

$$v_k = w_k\, w_{k-1} ... w_{k-K} \qquad (9)$$

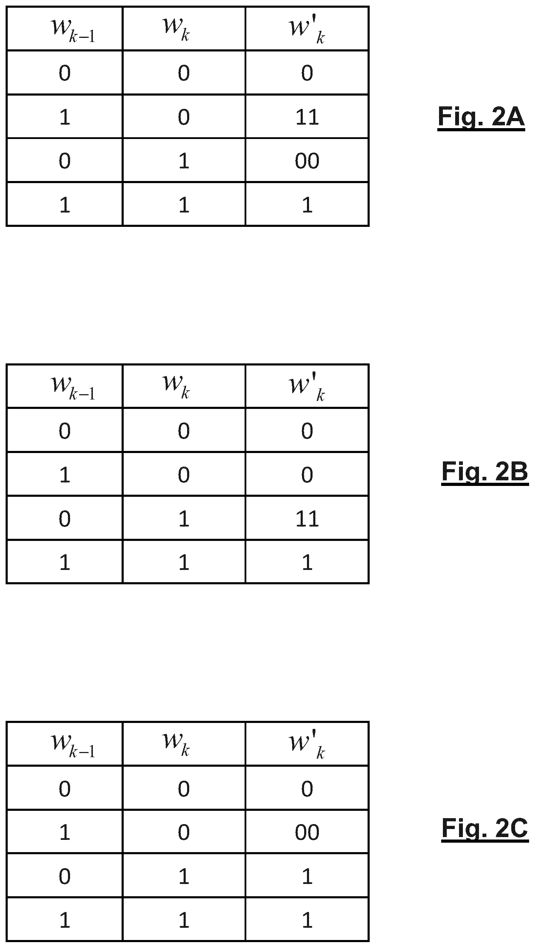

La Fig. 2A donne un premier exemple de table de transcodage lorsque $K = 1$ et $m = 1$, autrement dit lorsque les mots se réduisent à un seul bit et l'état du transcodeur ne dépend que du bit précédent.

Dans cet exemple, on voit que les bits 0 et 1 sont laissés invariants si le bit précédent est de même valeur que le bit courant (2 premières lignes de la table) alors qu'une transition binaire 0→1 (resp. 1→0) se traduit par un mot de code de longueur 2, soit 00 si le bit précédent était 0 et 11 si le précédent était 1 (cf. les 2ème et 3ème lignes de la table). Le nombre de transitions au sein de la séquence $v'_k$ est donc ici nul dans tous les cas.

Ainsi, par exemple, la séquence de bits 0101 en entrée du transcodeur se traduit elle en sortie par une séquence 0001100. La sortie du modulateur 130 est donnée par la séquence de symboles $e^{-j\frac{\Phi}{2}}$, $e^{-j\frac{\Phi}{2}}$, $e^{-j\frac{\Phi}{2}}$, $e^{+j\frac{\Phi}{2}}$, $e^{+j\frac{\Phi}{2}}$, $e^{-j\frac{\Phi}{2}}$, $e^{-j\frac{\Phi}{2}}$ à la fréquence $1/T_s$, alors qu'en absence de transcodage, cette séquence aurait été $e^{-j\frac{\Phi}{2}}$, $e^{+j\frac{\Phi}{2}}$, $e^{-j\frac{\Phi}{2}}$, $e^{+j\frac{\Phi}{2}}$ à la même fréquence. On comprendra que la densité de transitions de phase par unité de temps est plus faible et que par conséquent le spectre du signal modulé présente une largeur de bande réduite.

Un second exemple de table de transcodage est donné par la Fig. 2B, pour $K = 1$ et $m = 1$.

Dans cet exemple, seule la transition 0→1 se traduit par un mot de code de longueur 2, ici 11 mais 00 aurait également pu convenir (ligne 3 de la table).

Le transcodage laisse le bit $w_k$ invariant pour les autres séquences $v_k$.

Un troisième exemple de table de transcodage est donné par la Fig. 2C, pour $K = 1$ et $m = 1$.

Dans cet exemple, seule la transition 1→0 est remplacée par un mot de longueur 2 sans transition interne (ici 00 mais 11 aurait également pu convenir) (ligne 3 de la table).

Le transcodage laisse le bit $w_k$ invariant pour les autres séquences $v_k$.

On comprendra que les tables de transcodage données dans les second et troisième exemples permettent d'obtenir une vitesse de modulation plus élevée que dans le premier exemple, au prix toutefois d'un spectre de signal modulé plus large.

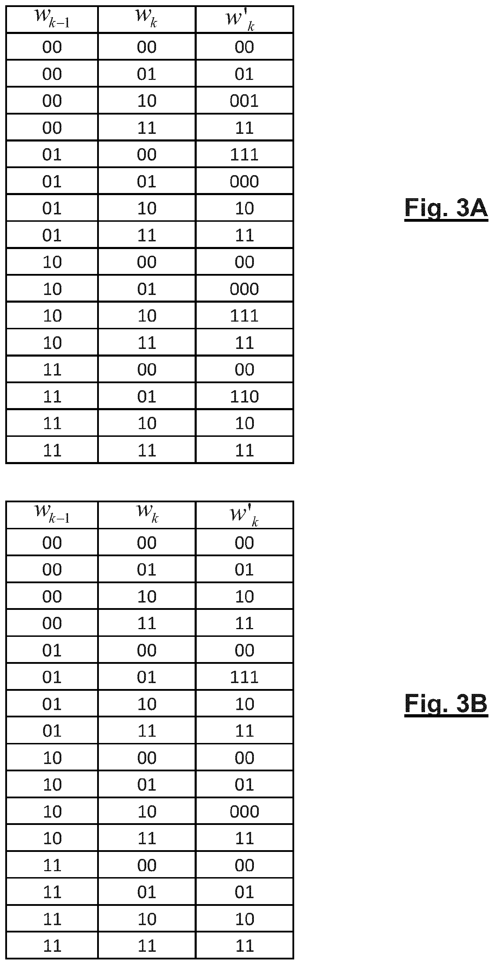

La Fig. 3A donne un quatrième exemple de table de transcodage lorsque $K=1$ et $m=2$.

On a représenté en colonne de gauche le mot précédent, $w_{k-1}$, déterminant l'état $e_k$ du transcodeur et en colonne de gauche, le mot courant à coder, $w_k$, chaque ligne correspondant à une séquence $v_k$ différente.

On remarque que deux de ces séquences comportent 3 transitions (lignes 5 et 11). Les mots $w_k$ correspondant à ces séquences sont codés en des mots de code de longueur variable, $w'_k$, à savoir 111 et 000.

On remarque également que six de ces séquences comportent 2 transitions (lignes 3, 5, 7, 10, 12, 14). Pour certaines de ces séquences, les mots $w_k$ sont codés en des mots de longueur variable (lignes 3, 5, 10, 14), les autres restant invariants par le transcodage.

La Fig. 3B donne un cinquième exemple de table de transcodage lorsque $K=1$ et $m=2$.

Ce cinquième exemple se distingue du précédent en ce que seuls les mots $w_k$ conduisant à des séquences $v_k$ ayant le nombre maximal de transitions (3) sont codés par des mots $w'_k$ de longueur 3, les autres mots restant inchangés dans le transcodage.

On comprend que le cinquième exemple permet d'obtenir une vitesse de modulation plus élevée que dans le quatrième exemple, au prix toutefois d'un spectre de signal modulé plus large.

De manière plus générale, un transcodeur dont les mots d'entrée sont de taille $m$ et dont l'état $e_k$ à l'instant $k$ dépend des $K$ mots précédents $w_{k-1},..., w_{k-K}$, comprendra une table de transcodage $T$ dans laquelle au moins un mot $w_k$ conduisant à une séquence $v_k = w_k w_{k-1}...w_{k-K}$ présentant un nombre $\mu_k$ de transitions binaire est codé en un mot $w'_k$ tel que la séquence $v'_k = w'_k w_{k-1}...w_{k-K}$ présente un nombre de transitions binaires $\mu'_k < \mu_k$, chaque transition binaire correspondant à une transition de phase dans la séquence de symboles de modulation 2-PSK.

De préférence, la table de transcodage code un mot $w_k$ conduisant à une séquence $v_k = w_k w_{k-1}...w_{k-K}$ présentant un nombre maximal $\mu_k = (K+1)m-1$ de transitions est codé en un mot $w'_k$ de taille $m+1$, dont tous les bits ont la même valeur.

Le cas échéant, d'autres mots $w_k$ donnant lieu à une séquence $v_k = w_k w_{k-1}...w_{k-K}$ présentant un nombre de transitions égal à $(K+1)m-2$ sont codés par des mots $w'_k$ de taille $m+1$ tels que la séquence $v'_k = w'_k w_{k-1}...w_{k-K}$ présente un nombre de transitions inférieur à $(K+1)m-2$.

D'une manière encore plus générale, lorsque les mots d'entrée $w_k$ sont constitués de $m$ symboles d'information et dont l'état $e_k$ du transcodeur à l'instant $k$ dépend des $K$ mots précédents $w_{k-1},..., w_{k-K}$, le transcodeur comprend une table de transcodage $T$ dans laquelle au moins un mot $w_k$ conduisant à une séquence $v_k = w_k w_{k-1}...w_{k-K}$ présentant un nombre $\mu_k$ de transitions de symboles d'information est codé en un mot $W'_k$ tel que la séquence $v'_k = w'_k w_{k-1}...w_{k-K}$ présente un nombre de transitions de symboles d'information $\mu'_k < \mu_k$, chaque transition de symbole d'information correspondant à une transition de phase dans la séquence de symboles de modulation M-PSK.

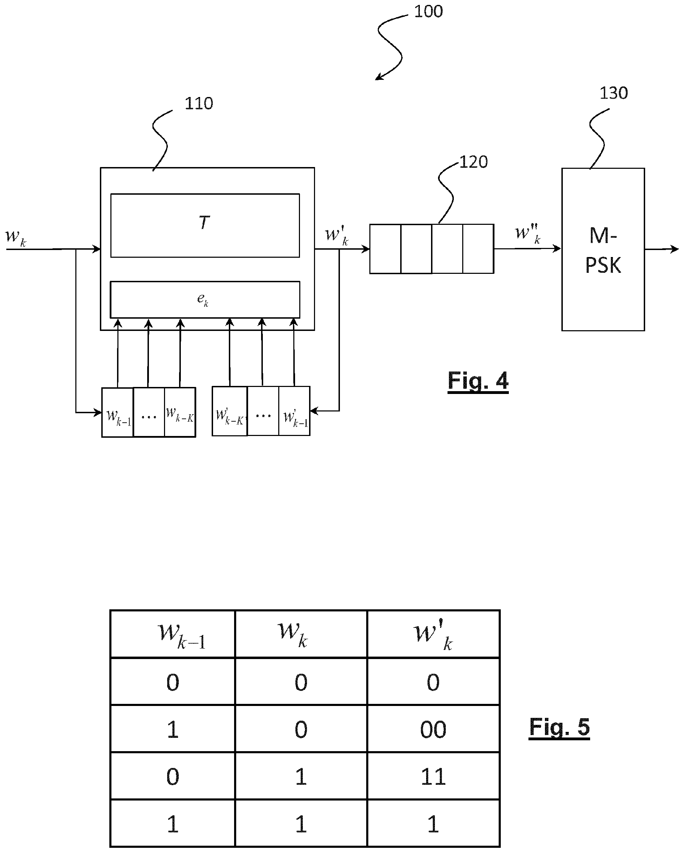

La Fig. 4 représente de manière schématique un dispositif de modulation numérique selon un second mode de réalisation de l'invention.

Comme dans le premier mode de réalisation, le système de modulation numérique, 100, comprend un transcodeur, 110, transformant les mots de $m$ symboles d'information en mots de longueur variable selon une table de transcodage $T$.

Le transcodeur fonctionne comme une machine à états finis, autrement dit le mot de longueur variable fourni en sortie à chaque période de codage $k$ dépend de l'état du transcodeur et du mot présent à son entrée, comme indiqué par l'expression (7).

Toutefois, à la différence du premier mode de réalisation l'état $e_k$ peut dépendre des $K$ derniers mots précédents $w_{k-1},..., w_{k-K}$ et des $K'$ derniers mots de sortie, $w'_{k-1},..., w'_{k-K'}$ où $K'$ est un entier. On comprendra que le premier mode de réalisation peut être considéré comme un cas particulier du second avec $K' = 0$.

Le reste du dispositif de modulation numérique est inchangé, les mots de longueur variable, $w'_k$, sont stockés les uns à la suite des autres dans un registre FIFO First In First Out), 120, qui fournit un mot de $m$ symboles d'information à chaque période de modulation, et chaque symbole d'information est ensuite transformé en un symbole M-PSK par le modulateur 130.

La Fig. 5 représente un sixième exemple de table de transcodage pour un cas particulier de dispositif de modulation numérique de la Fig. 4.

Plus précisément, on suppose dans ce cas particulier que $K = 1$; $K' = 1$; $m = 1$ et que les symboles d'information sont des bits. L'état du transcodeur dépend du bit $w_{k-1}$ précédemment en entrée du transcodeur et du dernier bit du mot $w'_{k-1}$ précédemment en sortie ce celui-ci.

Si l'on suppose que la table de transcodage est donnée par la Fig. 5 et que la séquence de symboles binaires en entrée est 0,0,1,0,1,0,0,0,1, la séquence de symboles binaires en sortie est alors (en supposant l'état initial arbitrairement fixé à 1) :

Séquence d'entrée :
0 0 1 0 1 0 0 0 1

Séquence de sortie :
0̲ 0̲ 11 00 11 00 0̲ 0̲ 11

où les bits soulignés de la séquence de sortie sont pris en compte pour la détermination de l'état du transcodeur à la période suivante.

**Revendications**

1. Méthode de modulation numérique transformant une séquence de mots d'entrée ($w_k$), constitués chacun de $m$ symboles d'information, en une séquence de symboles de modulation M-PSK où $M = 2^m$, **caractérisée en ce qu'**elle comprend :

   - une étape de transcodage dans laquelle chaque mot d'entrée ($w_k$) est codé en un mot de code ($w'_k$) de longueur variable au moyen d'une table de transcodage, la table de transcodage codant au moins un premier mot d'entrée, induisant un premier nombre de transitions de phase dans ladite séquence de symboles de modulation, en un second mot de taille supérieure à $m$, induisant un second nombre de transitions de phase inférieur au dit premier nombre dans ladite séquence ;
   - une étape de concaténation des mots de code ($w'_k$) obtenus à l'étape précédente pour fournir une séquence de mots de sortie ($w''_k$), chaque mot de sortie étant constitué de $m$ symboles d'information;
   - une modulation M-PSK fournissant pour chaque mot de sortie de la séquence un symbole M-PSK correspondant.

2. Méthode de modulation numérique selon la revendication 1, **caractérisée en ce que** la table de transcodage fournit un mot de code $w'_k$ pour chaque mot d'entrée $w_k$, le mot de code $w'_k$ dépendant du mot d'entrée en question ainsi que de l'état du transcodeur, l'état du transcodeur étant déterminé par les $K$ derniers mots d'entrée du transcodeur et les $K'$ derniers mots de code fournis par le transcodeur, où $K$ et $K'$ sont des entiers supérieurs ou égaux à 1

3. Méthode de modulation numérique selon la revendication 1, **caractérisée en ce que** la table de transcodage fournit un mot de code $w'_k$ pour chaque mot d'entrée $w_k$, le mot de code $w'_k$ dépendant du mot d'entrée en question ainsi que de l'état du transcodeur, l'état du transcodeur étant déterminé par les $K$ derniers mots d'entrée du transcodeur, où $K$ est un entier supérieur ou égal à 1.

4. Méthode de modulation numérique selon la revendication 3, **caractérisée en ce que** les symboles d'information sont constitués chacun par un bit et que les mots d'entrée ainsi que les mots de sortie sont binaires, et que $M = 2$.

5. Méthode de modulation numérique selon la revendication 4, **caractérisée en ce qu'**un mot binaire d'entrée $w_k$ induisant dans la séquence de symboles de modulation $\mu_k = (K+1)m-1$ transitions de phase est codé en un mot $w'_k$ de taille $m+1$, dont tous les bits ont la même valeur.

6. Méthode de modulation numérique selon la revendication 4, **caractérisée en ce que** $K = 1$ et $m= 1$, la table de transcodage étant donnée par :

| $w_{k-1}$ | $w_k$ | $w'_k$ |
|:---:|:---:|:---:|
| 0 | 0 | 0 |
| 1 | 0 | 11 |
| 0 | 1 | 00 |
| 1 | 1 | 1 |

7. Méthode de modulation numérique selon la revendication 4, **caractérisée en ce que** $K = 1$ et $m= 1$, la table de transcodage étant donnée par :

| $w_{k-1}$ | $w_k$ | $w'_k$ |
|:---:|:---:|:---:|
| 0 | 0 | 0 |
| 1 | 0 | 0 |
| 0 | 1 | 11 |
| 1 | 1 | 1 |

**8.** Méthode de modulation numérique selon la revendication 4, **caractérisée en ce que** $K$ = 1 et $m$= 1, la table de transcodage étant donnée par :

| $w_{k-1}$ | $w_k$ | $w'_k$ |
|-----------|-------|--------|
| 0 | 0 | 0 |
| 1 | 0 | 00 |
| 0 | 1 | 1 |
| 1 | 1 | 1 |

**9.** Méthode de modulation numérique selon l'une quelconque des revendications 4 à 8, **caractérisée en ce que** l'étape de modulation 2-PSK transforme un bit d'une première valeur en $e^{-j\frac{\Phi}{2}}$ et un bit d'une seconde valeur, inverse de la première valeur en $e^{+j\frac{\Phi}{2}}$ où $\Phi$ est un angle inférieur à $\pi/2$.

**10.** Modulateur numérique transformant une séquence de mots d'entrée ($w_k$), constitués chacun de $m$ symboles d'information, en une séquence de symboles de modulation M-PSK où $M = 2^m$, **caractérisé en ce qu'**il comprend :

- un transcodeur (110) dans lequel chaque mot d'entrée est codé en un mot de code de longueur variable au moyen d'une table de transcodage stockée au sein du transcodeur, la table de transcodage codant au moins un premier mot, induisant un premier nombre de transitions de phase dans ladite séquence de symboles de modulation, en un second mot de taille supérieure à $m$ induisant un second nombre de transitions de phase inférieur au dit premier nombre dans ladite séquence ;
- un registre FIFO (120) adapté à concaténer des mots de code obtenus à l'étape précédente pour fournir une séquence de mots de sortie $(W''_k)$, chaque mot de sortie étant constitué de $m$ symboles d'information;
- un modulateur M-PSK (130) fournissant pour chaque mot de sortie un symbole M-PSK correspondant.

**11.** Modulateur numérique selon la revendication 10, **caractérisé en ce que** la table de transcodage fournit un mot de code $w'_k$ pour chaque mot d'entrée $w_k$, le mot de code $w'_k$ dépendant du mot binaire en question ainsi que de l'état du transcodeur, l'état du transcodeur étant déterminé par les $K$ derniers mots d'entrée du transcodeur et les $K'$ derniers mots de code fournis par le transcodeur, où $K$ et $K'$ sont des entiers supérieurs ou égaux à 1.

**12.** Modulateur numérique selon la revendication 10, **caractérisé en ce que** la table de transcodage fournit un mot de code $w'_k$ pour chaque mot d'entrée $w_k$, le mot de code $w'_k$ dépendant du mot binaire en question ainsi que de l'état du transcodeur, l'état du transcodeur étant déterminé par les $K$ derniers mots binaires en entrée du transcodeur, où $K$ est un entier supérieur ou égal à 1.

**Patentansprüche**

**1.** Verfahren zur digitalen Modulation, das eine Sequenz von Eingangswörtern ($w_k$), die jeweils durch $m$ Informationssymbole gebildet sind, in eine Sequenz von Modulationssymbolen M-PSK transformiert, wobei $M = 2^m$, **dadurch gekennzeichnet, dass** es umfasst:

- einen Schritt der Transkodierung, in dem jedes Eingangswort ($w_k$) in ein Codewort ($w'_k$) von variabler Länge mit Hilfe einer Transkodierungstabelle kodiert wird, wobei die Transkodierungstabelle wenigstens ein erstes Eingangswort unter Induzieren einer ersten Zahl von Phasenübergängen in der Sequenz von Modulationssymbolen in ein zweites Wort mit einer Größe größer als $m$ unter Induzieren einer zweiten Zahl von Phasenübergängen, die kleiner ist als die erste Zahl, in der Sequenz kodiert:
- einen Schritt der Verknüpfung der Codewörter ($w'_k$), die im vorhergehenden Schritt erhalten werden, um eine Sequenz von Ausgangswörtern $(W''_k)$ zu liefern, wobei jedes Ausgangswort durch $m$ Informationssymbole gebildet ist;
- eine Modulation M-PSK, die für jedes Ausgangswort der Sequenz ein entsprechendes Symbol M-PSK liefert.

**2.** Verfahren zur digitalen Modulation nach Anspruch 1, **dadurch gekennzeichnet, dass** die Transkodierungstabelle ein Codewort $w'_k$ für jedes Eingangswort $w_k$ liefert, wobei das Codewort $w'_k$ vom fraglichen Eingangswort ebenso wie vom Zustand des Transkodierers abhängt, wobei der Zustand des Transkodierers bestimmt wird durch die $K$ letzten Eingangswörter des Transkodierers, und die $K'$ letzten Codewörter, die durch den Transkodierer geliefert werden, wobei $K$ und $K'$ ganze Zahlen größer oder gleich 1 sind.

**3.** Verfahren zur digitalen Modulation nach Anspruch 1, **dadurch gekennzeichnet, dass** die Transkodierungstabelle ein Codewort $w'_k$ für jedes Eingangswort $W_k$ liefert, wobei das Codewort $w'_k$ vom fraglichen Eingangswort sowie vom Zustand des Transkodierers abhängt, wobei der Zustand des Transkodierers durch die $K$ letzten Eingangswörter des Transkodierers bestimmt wird, wobei $K$ eine ganze Zahl größer oder gleich 1 ist.

**4.** Verfahren zur digitalen Modulation nach Anspruch 3, **dadurch gekennzeichnet, dass** die Informationssymbole jeweils durch ein Bit gebildet sind, und dass die Eingangswörter sowie die Ausgangswörter binär sind, und dass $M = 2$.

**5.** Verfahren zur digitalen Modulation nach Anspruch 4, **dadurch gekennzeichnet, dass** ein binäres Eingangswort $W_k$, das in der Sequenz von Modulationssymbolen $\mu_k = (K+1)m$-1 Phasenübergänge induziert, in ein Wort $w'_k$ der Größe $m$+1 kodiert wird, dessen Bits alle den gleichen Wert haben.

**6.** Verfahren zur digitalen Modulation nach Anspruch 4, **dadurch gekennzeichnet, dass** $K = 1$ und $m = 1$, wobei die Transkodierungstabelle gegeben ist durch:

| $w_{k-1}$ | $w_k$ | $w'_k$ |
|---|---|---|
| 0 | 0 | 0 |
| 1 | 0 | 11 |
| 0 | 1 | 00 |
| 1 | 1 | 1 |

**7.** Verfahren zur digitalen Modulation nach Anspruch 4, **dadurch gekennzeichnet, dass** $K = 1$ und $m = 1$, wobei die Transkodierungstabelle gegeben ist durch:

| $w_{k-1}$ | $w_k$ | $w'_k$ |
|---|---|---|
| 0 | 0 | 0 |
| 1 | 0 | 0 |
| 0 | 1 | 11 |
| 1 | 1 | 1 |

**8.** Verfahren zur digitalen Modulation nach Anspruch 4, **dadurch gekennzeichnet, dass** $K = 1$ und $m = 1$, wobei die Transkodierungstabelle gegeben ist durch:

| $w_{k-1}$ | $w_k$ | $w'_k$ |
|---|---|---|
| 0 | 0 | 0 |
| 1 | 0 | 00 |
| 0 | 1 | 1 |
| 1 | 1 | 1 |

9.  Verfahren zur digitalen Modulation nach einem der Ansprüche 4 bis 8, **dadurch gekennzeichnet, dass** der Schritt der Modulation 2-PKS ein Bit eines ersten Werts in $e^{-j\frac{\Phi}{2}}$ transformiert, und ein Bit eines zweiten Werts, invers zum ersten Wert, in $e^{+j\frac{\Phi}{2}}$, wobei $\Phi$ ein Winkel kleiner als $\pi/2$ ist.

10. Digitaler Modulierer, der eine Sequenz von Eingangswörtern ($w_k$), die jeweils aus $m$ Informationssymbolen gebildet sind, in eine Sequenz von Modulationssymbolen M-PSK transformiert, wobei $M = 2^m$, **dadurch gekennzeichnet, dass** er umfasst:

    - einen Transkodierer (110), in dem jedes Eingangswort kodiert wird in ein Codewort von variabler Länge mit Hilfe einer Transkodierungstabelle, die innerhalb des Transkodierers gespeichert ist, wobei die Transkodierungstabelle wenigstens ein erstes Wort unter Induzieren einer ersten Zahl von Phasenübergängen in der Sequenz von Modulationssymbolen in ein zweites Wort mit einer Größe größer als $m$ unter Induzieren einer zweiten Zahl von Phasenübergängen, die kleiner ist als die erste Zahl, in der Sequenz kodiert;
    - ein FIFO-Register (120), das dazu ausgelegt ist, Codewörter zu verknüpfen, die im vorhergehenden Schritt erhalten werden, um eine Sequenz von Ausgangswörtern ($W_k''$) zu liefern, wobei jedes Ausgangswort durch $m$ Informationssymbole gebildet ist;
    - einen Modulator M-PSK (130), der für jedes Ausgangswort ein entsprechendes Symbol M-PSK liefert.

11. Digitaler Modulierer nach Anspruch 10, **dadurch gekennzeichnet, dass** die Transkodierungstabelle ein Codewort $w'_k$ für jedes Eingangswort $W_k$ liefert, wobei das Codewort $w'_k$ vom fraglichen binären Wort sowie vom Zustand des Transkodierers abhängt, wobei der Zustand des Transkodierers bestimmt ist durch die $K$ letzten Eingangswörter des Transkodierers, und die $K'$ letzten Codewörter, die durch den Transkodierer geliefert sind, wobei $K$ und $K'$ ganze Zahlen größer oder gleich 1 sind.

12. Digitaler Modulierer nach Anspruch 10, **dadurch gekennzeichnet, dass** die Transkodierungstabelle ein Codewort $w'_k$ für jedes Eingangswort $W_k$ liefert, wobei das Codewort $w'_k$ vom fraglichen binären Wort sowie vom Zustand des Transkodierers abhängt, wobei der Zustand des Transkodierers bestimmt ist durch die $K$ letzten binären Wörter am Eingang des Transkodierers, wobei $K$ eine ganze Zahl größer oder gleich 1 ist.

**Claims**

1.  Digital modulation method transforming a sequence of input words ($w_k$), each constituted of $m$ information symbols, into a sequence of M-PSK modulation symbols where $M = 2^m$, **characterised in that** it comprises:

    - a step of transcoding wherein each input word ($w_k$) is coded into a code word ($w'_k$) of variable length by means of a transcoding table, the transcoding table coding at least one first input word, leading to a first number of phase transitions in said sequence of modulation symbols, into a second word of size greater than $m$, leading to a second number of phase transitions less than said first number in said sequence;
    - a step of concatenation of the code words ($w'_k$) obtained at the preceding step to supply a sequence of output words ($W_k''$), each output word being constituted of $m$ information symbols;
    - a M-PSK modulation supplying for each output word of the sequence a corresponding M-PSK symbol.

2.  Digital modulation method according to claim 1, **characterised in that** the transcoding table supplies a code word $w'_k$ for each input word $w_k$, the code word $w'_k$ depending on the input word in question as well as the state of the transcoder, the state of the transcoder being determined by the $K$ last input words of the transcoder and the $K'$ last code words supplied by the transcoder, where $K$ and $K'$ are integers greater than or equal to 1

3.  Digital modulation method according to claim 1, **characterised in that** the transcoding table supplies a code word $w'_k$ for each input word $w_k$, the code word $w'_k$ depending on the input word in question as well as on the state of the transcoder, the state of the transcoder being determined by the $K$ last input words of the transcoder, where $K$ is an integer greater than or equal to 1.

4. Digital modulation method according to claim 3, **characterised in that** the information symbols are each constituted of a bit and that the input words as well as the output words are binary, and that $M = 2$.

5. Digital modulation method according to claim 4, **characterised in that** an input binary word $w_k$ leading to in the sequence of modulation symbols $\mu_k = (K+1)m\text{-}1$ phase transitions is coded into a word $w'_k$ of size $m+1$, all of the bits of which have the same value.

6. Digital modulation method according to claim 4, **characterised in that** $K = 1$ and $m = 1$, the transcoding table being given by:

| $w_{k-1}$ | $w_k$ | $w'_k$ |
|---|---|---|
| 0 | 0 | 0 |
| 1 | 0 | 11 |
| 0 | 1 | 00 |
| 1 | 1 | 1 |

7. Digital modulation method according to claim 4, **characterised in that** $K = 1$ and $m = 1$, the transcoding table being given by:

| $w_{k-1}$ | $w_k$ | $w'_k$ |
|---|---|---|
| 0 | 0 | 0 |
| 1 | 0 | 0 |
| 0 | 1 | 11 |
| 1 | 1 | 1 |

8. Digital modulation method according to claim 4, **characterised in that** $K = 1$ and $m = 1$, the transcoding table being given by:

| $w_{k-1}$ | $w_k$ | $w'_k$ |
|---|---|---|
| 0 | 0 | 0 |
| 1 | 0 | 00 |
| 0 | 1 | 1 |
| 1 | 1 | 1 |

9. Digital modulation method according to any of claims 4 to 8, **characterised in that** the step of 2-PSK modulation transforms a bit from a first value into $e^{-j\frac{\Phi}{2}}$ and a bit of a second value, opposite to the first value, into $e^{+j\frac{\Phi}{2}}$ where $\Phi$ is an angle less than $\pi/2$.

10. Digital modulator transforming a sequence of input words ($w_k$), each constituted of $m$ information symbols, into a sequence of M-PSK modulation symbols where $M = 2^m$, **characterised in that** it comprises:

- a transcoder (110) wherein each input word is coded into a code word of variable length using a transcoding table stored within the transcoder, the transcoding table coding at least one first word, leading to a first number of phase transitions in said sequence of modulation symbols, into a second word of size greater than $m$ leading to a second number of phase transitions less than said first number in said sequence;

- a FIFO register (120) adapted to concatenate code words obtained at the preceding step to supply a sequence of output words $(W_k'')$, each output word being constituted of $m$ information symbols;
- a M-PSK modulator (130) supplying for each output word a corresponding M-PSK symbol.

11. Digital modulator according to claim 10, **characterised in that** the transcoding table supplies a code word $w'_k$ for each input word $w_k$, the code word $w'_k$ depending on the binary word in question as well as on the state of the transcoder, the state of the transcoder being determined by the $K$ last input words of the transcoder and the $K'$ last code words supplied by the transcoder, where $K$ and $K'$ are whole numbers greater than or equal to 1.

12. Digital modulator according to claim 10, **characterised in that** the transcoding table supplies a code word $w'_k$ for each input word $w_k$, the code word $w'_k$ depending on the binary word in question as well as on the state of the transcoder, the state of the transcoder being determined by the $K$ last binary words at the input of the transcoder, where $K$ is a whole number greater than or equal to 1.

**Fig. 1**

| $w_{k-1}$ | $w_k$ | $w'_k$ |
|:---:|:---:|:---:|
| 0 | 0 | 0 |
| 1 | 0 | 11 |
| 0 | 1 | 00 |
| 1 | 1 | 1 |

**Fig. 2A**

| $w_{k-1}$ | $w_k$ | $w'_k$ |
|:---:|:---:|:---:|
| 0 | 0 | 0 |
| 1 | 0 | 0 |
| 0 | 1 | 11 |
| 1 | 1 | 1 |

**Fig. 2B**

| $w_{k-1}$ | $w_k$ | $w'_k$ |
|:---:|:---:|:---:|
| 0 | 0 | 0 |
| 1 | 0 | 00 |
| 0 | 1 | 1 |
| 1 | 1 | 1 |

**Fig. 2C**

| $w_{k-1}$ | $w_k$ | $w'_k$ |
|-----------|-------|--------|
| 00 | 00 | 00 |
| 00 | 01 | 01 |
| 00 | 10 | 001 |
| 00 | 11 | 11 |
| 01 | 00 | 111 |
| 01 | 01 | 000 |
| 01 | 10 | 10 |
| 01 | 11 | 11 |
| 10 | 00 | 00 |
| 10 | 01 | 000 |
| 10 | 10 | 111 |
| 10 | 11 | 11 |
| 11 | 00 | 00 |
| 11 | 01 | 110 |
| 11 | 10 | 10 |
| 11 | 11 | 11 |

**Fig. 3A**

| $w_{k-1}$ | $w_k$ | $w'_k$ |
|-----------|-------|--------|
| 00 | 00 | 00 |
| 00 | 01 | 01 |
| 00 | 10 | 10 |
| 00 | 11 | 11 |
| 01 | 00 | 00 |
| 01 | 01 | 111 |
| 01 | 10 | 10 |
| 01 | 11 | 11 |
| 10 | 00 | 00 |
| 10 | 01 | 01 |
| 10 | 10 | 000 |
| 10 | 11 | 11 |
| 11 | 00 | 00 |
| 11 | 01 | 01 |
| 11 | 10 | 10 |
| 11 | 11 | 11 |

**Fig. 3B**

100

110

$w_k$ ⟶ | T | ⟶ $w'_k$

$e_k$

$w_{k-1}$ | ... | $w_{k-K}$    $w'_{k-K}$ | ... | $w'_{k-1}$

120

$w''_k$ ⟶ | M-PSK | ⟶

130

**Fig. 4**

| $w_{k-1}$ | $w_k$ | $w'_k$ |
|-----------|-------|--------|
| 0 | 0 | 0 |
| 1 | 0 | 00 |
| 0 | 1 | 11 |
| 1 | 1 | 1 |

**Fig. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LITZENBURGER.** *A comparison of trellis shaping schemes for controlling the envelope of a bandlimited PSK-signal,* 08 Juin 1994, 982-986